(19) Europäisches Patentamt
European Patent Office
Office européen des brevets

(11) Veröffentlichungsnummer: **0 054 151**
**B1**

(12) # EUROPÄISCHE PATENTSCHRIFT

(45) Veröffentlichungstag der Patentschrift: **04.01.84**

(21) Anmeldenummer: **81108811.1**

(22) Anmeldetag: **23.10.81**

(51) Int. Cl.³: **G 03 C 1/70,** G 03 C 1/68, G 03 F 7/10, G 03 F 7/26, C 08 G 69/48

(54) **Photopolymerisierbares Aufzeichnungsmaterial und Verfahren zur Herstellung von Reliefformen mittels dieses Aufzeichnungsmaterials.**

(30) Priorität: **13.12.80 DE 3047126**

(43) Veröffentlichungstag der Anmeldung: **23.06.82 Patentblatt 82/25**

(45) Bekanntmachung des Hinweises auf die Patenterteilung: **04.01.84 Patentblatt 84/1**

(84) Benannte Vertragsstaaten: **BE CH DE FR GB IT LI NL**

(56) Entgegenhaltungen: **DE - A - 2 116 591**

(73) Patentinhaber: **BASF Aktiengesellschaft, Carl-Bosch-Strasse 38, D-6700 Ludwigshafen (DE)**

(72) Erfinder: **Lehner, August, Wachenheimerstrasse 13, D-6701 Roedersheim (DE)**
Erfinder: **Werther, Heinz Ulrich, Dr., Hoffmannstrasse 12, D-6706 Wachenheim (DE)**
Erfinder: **Naegele, Dieter, Dr., Obere Jakobsstrasse 8, D-6520 Worms (DE)**
Erfinder: **Lenz, Werner, Dr., Heinrich Baermann Strasse 14, D-6702 Bad Duerkheim (DE)**
Erfinder: **Jun, Mong Jon, Dr., Maulbeerstueck 20, D-6720 Speyer (DE)**
Erfinder: **Reimann, Horst, Dr., Adelheitstrasse 26, D-6520 Worms (DE)**
Erfinder: **Eckell, Albrecht, Dr., Paul-Klee-Strasse 2, D-6710 Frankenthal (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 054 151 B1

ACTORUM AG

# Photopolymerisierbares Aufzeichnungsmaterial und Verfahren zur Herstellung von Reliefformen mittels dieses Aufzeichnungsmaterials

Die vorliegende Erfindung betrifft ein photopolymerisierbares Aufzeichnungsmaterial mit einer auf einem Schichtträger aufgebrachten photopolymerisierbaren Schicht, bei dem die photopolymerisierbare Schicht neben einer photopolymerisierbaren, ethylenisch ungesättigten Verbindung, einem Photopolymerisationsinitiator sowie gegebenenfalls sonstigen üblichen Zusatzstoffen als Bindemittel ein modifiziertes Polyamid mit quaternären und/oder quaternisierbaren Stickstoffatomen enthält. Die Erfindung betrifft des weiteren Verfahren zur Herstellung von Reliefformen, wie z.B. Druckplatten oder Photoresists, mittels dieses photopolymerisierbaren Aufzeichnungsmaterials.

Es ist bekannt, Reliefdruckplatten oder Photoresists auf photochemischem Wege herzustellen, indem man eine auf einem Schichtträger aufgebrachte photopolymerisierbare Schicht bildweise mittels einer Strahlungsquelle, insbesondere aktinischem Licht, belichtet und die belichtete Photoschicht durch Behandeln mit einem Lösungsmittel entwickelt, in welchem die unbelichteten, nicht aber die belichteten Bereiche der Photoschicht löslich oder zumindest dispergierbar sind. Die photopolymerisierbare Schicht dieser Aufzeichnungsmaterialien enthält dabei im allgemeinen niedermolekulare photopolymerisierbare Verbindungen, Photoinitiatoren sowie ein polymeres Bindemittel, welches auch der Photopolymerisation oder Photovernetzung zugänglich sein kann. Die Anforderungen, die an solche photopolymerisierbaren Aufzeichnungsmaterialien und insbesondere auch an das polymere Bindemittel der photopolymerisierbaren Schicht gestellt werden, sind aus der einschlägigen Literatur bekannt. Es ist dabei heutzutage erstrebenswert, photopolymerisierbare Aufzeichnungsmaterialien zu schaffen, die nicht nur hinreichende mechanische und drucktechnische Eigenschaften besitzen, sondern darüber hinaus in umwelt- und arbeitsfreundlichen Lösungsmitteln entwickelbar sind.

Um zu photopolymerisierbaren Aufzeichnungsmaterialien zu gelangen, die einerseits gute mechanische Eigenschaften haben und andererseits nach der Belichtung mit Wasser oder verdünnter wässriger Säuren entwickelbar sind, wird in der DE-B- 24 54 676 ein lichtempfindliches Gemisch vorgeschlagen, das als polymeres Bindemittel ein Polyamid, einen Polyester oder ein Vinylpolymerisat mit eingebauten quaternären Stickstoff-Gruppierungen enthält. Ein Nachteil dieser lichtempfindlichen Gemische ist, dass die als Bindemittel eingesetzten Polymeren mit quaternären Stickstoff-Gruppierungen keine polymerisierbaren Doppelbindungen im Grundpolymer enthalten und somit bei der Photopolymerisation nicht mit einpolymerisiert werden können. Dies wirkt sich beispielsweise auf die Reaktivität und Belichtungseigenschaften der lichtempfindlichen Gemische wie auch auf die Eigenschaften der daraus hergestellten Aufzeichnungsmaterialien und Reliefdruckformen aus. Man kann diesen Nachteil wohl teilweise vermeiden, indem durch die Quaternisierung der Polymer-Bindemittel mit ungesättigten, photopolymerisierbaren Säuren, z.B. Acrylsäure oder Methacrylsäure, reaktionsfähige Doppelbindungen an das Grundpolymer angelagert werden; in diesem Fall muss man aber die bekannt negativen Eigenschaften z.B. der (Meth)acrylsäure in Kauf nehmen.

Aufgabe der vorliegenden Erfindung ist es, ein mit Wasser oder wässrigen Medien entwickelbares Aufzeichnungsmaterial mit einer photopolymerisierbaren Schicht auf Polyamid-Basis aufzuzeigen, das die Nachteile der aus dem Stand der Technik bekannten Aufzeichnungsmaterialien dieser Art nicht oder nur in geringerem Umfang aufweist. Insbesondere soll das photopolymerisierbare Aufzeichnungsmaterial leicht herstellbar, bereits vor der Belichtung leicht handhabbar und verarbeitbar sein und eine möglichst geringe Haut- und Kontaktgiftigkeit besitzen. Das Aufzeichnungsmaterial soll sich zur Herstellung von Reliefdruckplatten und Photoresists eignen, dementsprechend gute Belichtungseigenschaften und hohes Auflösungsvermögen sowie nach der Belichtung und Entwicklung eine hohe mechanische Festigkeit und gute Druckeigenschaften bei gleichzeitig hoher Wiederverwendbarkeit besitzen.

Es wurde überraschenderweise gefunden, dass diese Aufgabe gelöst wird, wenn das photopolymerisierbare Aufzeichnungsmaterial in der photopolymerisierbaren Schicht als Bindemittel ein Diisocyanat-modifiziertes Polyamid enthält, welches im wesentlichen linear, bei Raumtemperatur fest, hochmolekular und thermoplastisch ist und das seitenständige photopolymerisierbare Doppelbindungen und quaternäre und/oder quaternisierbare Stickstoff-Atome eingebaut enthält.

Gegenstand der vorliegenden Erfindung ist demzufolge ein photopolymerisierbares Aufzeichnungsmaterial mit einem Schichtträger A, einer damit direkt oder indirekt haftfest verbundenen photopolymerisierbaren Schicht B sowie gegebenenfalls einer Deckschicht und/oder Deckfolie C, bei dem die photopolymerisierbare Schicht B enthält

1. als polymeres Bindemittel ein in einem Lösungsmittel lösliches, im wesentlichen lineares, bei Raumtemperatur festes, hochmolekulares, thermoplastisches Polymer mit eingebauten quaternären und/oder quaternisierbaren Stickstoff-Atomen,

2. mindestens eine photopolymerisierbare, ethylenisch ungesättigte Verbindung,

3. einen Photopolymerisationsinitiator sowie

4. gegebenenfalls sonstige übliche Zusatzstoffe, welches dadurch gekennzeichnet ist, dass das in der photopolymerisierbaren Schicht B als

Bindemittel (Komponente B1) enthaltene Polymer mit quaternären oder quaternisierbaren Stickstoff-Atomen ein Diisocyanat-modifiziertes Polyamid ist, das zusätzlich seitenständige photopolymerisierbare Doppelbindungen eingebaut enthält.

Gegenstand der Erfindung sind weiterhin spezielle Ausgestaltungsformen dieses photopolymerisierbaren Aufzeichnungsmaterials gemäss der nachfolgenden detaillierten Beschreibung. Gegenstand der Erfindung sind ferner Verfahren zur Herstellung von Reliefformen, wie z.B. von Reliefdruckplatten oder von Photoresists, mittels des photopolymerisierbaren Aufzeichnungsmaterials.

Es war überraschend, dass bei Einsatz der erfindungsgemässen Diisocyanat-modifizierten Polyamide als Bindemittel photopolymerisierbare Aufzeichnungsmaterialien mit insgesamt sehr guten Eigenschaften und einer Reihe besonderer Vorteile erhalten werden, die für die Herstellung von Reliefdruckplatten oder Photoresists geeignet sind. Aufgrund der guten mechanischen Eigenschaften der Diisocyanat-modifizierten Polyamide im Grundzustand besitzen die Aufzeichnungsmaterialien bereits vor der Belichtung ein hohes mechanisches Niveau und lassen sich die von der Anwendung her geforderten Eigenschaften der belichteten Materialien, wie z.B. Elastizität und Härte, in dem gewünschten Rahmen einstellen, ohne dass hierfür andere Nachteile, wie beispielsweise schlechte Belichtungseigenschaften, Verspröden oder geringe Alterungsbeständigkeit, in Kauf genommen werden müssen. Die Entwicklung der belichteten Materialien lässt sich in Wasser oder wässrigen Medien durchführen. Wegen des hohen Auflösevermögens der erfindungsgemässen Aufzeichnungsmaterialien geben die daraus hergestellten Reliefdruckplatten eine exakte Tonwertübertragung, wodurch sie besonders für die Wiedergabe von Halbtoneffekten günstig sind. Aufgrund ihrer mechanischen Eigenschaften und insbesondere der guten Abriebsfestigkeit besitzen diese Platten eine hohe Wiederverwendbarkeit, wobei auch die guten Farbaufnahme- und -abgabeeigenschaften von besonderem Vorteil sind.

Die in den erfindungsgemässen photopolymerisierbaren Aufzeichnungsmaterialien als Komponente B1 einzusetzenden Diisocyanat-modifizierten Polyamide sind im wesentlichen linear, bei Raumtemperatur fest und im allgemeinen nicht klebrig. Zur Erzielung möglichst günstiger mechanischer und verarbeitungstechnischer Eigenschaften soll ihr Erweichungspunkt vorteilhaft über 35°C, vorzugsweise über 55°C und insbesondere über 70°C liegen. Die erfindungsgemäss einzusetzenden Diisocyanat-modifizierten Polyamide (B1), die thermoplastisch verarbeitbar sein sollen, sollen dabei hochmolekular sein und weisen im allgemeinen K-Werte [nach Fikentscher, Cellulosechemie 13, 58 (1932)] zwischen 30 und 75 auf. Vorzugsweise liegen die K-Werte im Bereich von etwa 40 bis 60.

Die erfindungsgemäss einzusetzenden Diisocyanat-modifizierten Polyamide (B1) sollen darüber hinaus quaternäre und/oder quaternisierbare Stickstoffatome sowie seitenständige, der Photopolymerisation zugängliche Doppelbindungen eingebaut enthalten. Bei den quaternisierbaren Stickstoffatomen handelt es sich insbesondere um tertiäre Stickstoffatome, die in an und für sich bekannter Weise durch übliche Protonierungsmittel, wie z.B. anorganische und organische Säuren, oder Quaternierungsmittel, wie beispielsweise Alkylhalogenide, in den quaternären Ammoniumstickstoff überführt werden können. Es hat sich als vorteilhaft, jedoch nicht unbedingt notwendig erwiesen, wenn die Quaternisierung der Diisocyanat-modifizierten Polyamide bereits vor der Herstellung der photopolymerisierbaren Schicht (B) erfolgt, wobei die Quaternisierung möglichst vollständig sein soll, aber auch nur teilweise in an sich bekannter Weise durchgeführt werden kann. Es ist jedoch ebenso möglich, für die Herstellung der Aufzeichnungsmaterialien von Diisocyanat-modifizierten Polyamiden auszugehen, die nur quaternisierbare Stickstoffatome eingebaut enthalten, die dann bei der Entwicklung der bildmässig belichteten Aufzeichnungsmaterialien durch das für die Entwicklung eingesetzte Auswaschmittel quaternisiert werden können, wodurch die Auswaschgeschwindigkeit erhöht werden kann. Es hat sich gezeigt, dass die quaternären und/oder quaternisierbaren Stickstoffatome im Diisocyanat-modifizierten Polyamid (B1) nicht nur auf die Reaktivität bei der Photopolymerisation und die Auswaschbarkeit nach der Belichtung einen Einfluss haben, sondern dass sie auch für die sonstigen Eigenschaften des erfindungsgemässen photopolymerisierbaren Aufzeichnungsmaterials von Bedeutung sind. Die Diisocyanat-modifizierten Polyamide enthalten dabei etwa von 0,2 bis 2,5 Gew.% an quaternisierbaren und/oder quaternären Stickstoffatomen, bezogen auf das Gewicht des Diisocyanat-modifizierten Polyamids. Ausserhalb dieser Grenzen sind Produkteigenschaften, wie beispielsweise die Auswaschbarkeit in Wasser oder wässrigen Medien und die Elastizität, stark verschlechtert. Der Gehalt an quaternären und/oder quaternisierbaren Stickstoffatomen im Diisocyanat-modifizierten Polyamid (B1) richtet sich auch nach der Art des Diisocyanat-modifizierten Polyamids, wobei sich als vorteilhaft erwiesen hat, wenn das Diisocyanat-modifizierte Polyamid mindestens 0,4 Gew.%, und höchstens 1,8 Gew.%, vorzugsweise von 0,6 bis 1,2 Gew.% an quaternären und/oder quaternisierbaren Stickstoffatomen, bezogen auf das Gewicht des Diisocyanat-modifizierten Polyamids, eingebaut enthält.

Die in den erfindungsgemäss einzusetzenden Diisocyanat-modifizierten Polyamiden (B1) enthaltenen Doppelbindungen können grundsätzlich jeder beliebigen Art sein, sofern sie seitenständig zur Polymer-Hauptkette eingebaut und zur Teilnahme an der Photopolymerisation befähigt sind. Der Ausdruck «seitenständig zur Polymer-Hauptkette eingebaute Doppelbindungen» umfasst dabei nicht nur Doppelbindungen, die in einer einfach an die Polymer-Hauptkette gebundenen Seitenkette mit freiem Kettenende enthalten sind, sondern auch solche, die in einer doppelt an die Polymer-Hauptkette gebundenen Seitengruppe stehen. Es handelt sich hierbei in der Regel um Kohlenstoff-Kohlenstoff-Doppelbindungen, die in Seitengruppen mit freien Kettenenden vorteilhafterweise endständig stehen, insbesondere um acrylische Doppelbindungen oder ähnliche. Der Gehalt an den seitenständigen, photopolymerisierbaren Doppelbindungen in dem Diisocyanat-modifizierten Polyamid (B1) beträgt 0,01 bis 2,5 Gew.%, bezogen auf das Gewicht des Diisocyanat-modifizierten Polyamids. Der Anteil der seitenständigen photopolymerisierbaren Doppelbindungen im Diisocyanat-modifizierten Polyamid (B1) richtet sich dabei sowohl nach der Reaktivität der Doppelbindungen als auch nach dem angestrebten Vernetzungsgrad durch die Belichtung und damit zusammenhängend nach dem gewünschten Eigenschaftsbild des Aufzeichnungsmaterials. Es hat sich als vorteilhaft herausgestellt, wenn das Diisocyanat-modifizierte Polyamid (B1) mindestens 0,05 Gew.%, insbesondere mindestens 0,2 Gew.%, an eingebauten seitenständigen, photopolymerisierbaren Doppelbindungen, bezogen auf das Gewicht des Diisocyanat-modifizierten Polyamids, enthält. Je nach Art und Verwendungszweck des photopolymerisierbaren Aufzeichnungsmaterials ist es günstig, wenn der Gehalt an eingebauten seitenständigen, photopolymerisierbaren Doppelbindungen im Diisocyanat-modifizierten Polyamid (B1) nicht über 2 Gew.%, vorteilhaft nicht über 1,8 Gew.%, bezogen auf das Gewicht des Diisocyanat-modifizierten Polyamids, liegt. Das Gewicht einer Kohlenstoff-Kohlenstoff-Doppelbindung wird dabei mit 24 gerechnet.

Die erfindungsgemäss in der photopolymerisierbaren Schicht B als Bindemittel enthaltenen Diisocyanat-modifizierten Polyamide (B1) werden durch Umsetzung von im wesentlichen linearen Polyamiden, welche zwei im Sinne der Isocyanatchemie reaktionsfähige Wasserstoffatome tragen, mit Diisocyanaten, im Sinne der Isocyanatchemie bifunktionell reaktionsfähige tertiären Stickstoff-Verbindungen, geeigneten niedermolekularen olefinisch ungesättigten Verbindungen, die zwei im Sinne der Isocyanatchemie reaktionsfähige Wasserstoffatome tragen, sowie gegebenenfalls höhermolekularen Polydiolen und/oder niedermolekularen Diolen, Diaminen oder Aminoalkoholen, wie sie als Kettenverlängerer bei der Herstellung von Polyurethanen üblich sind, in an sich üblicher und bekannter Weise erhalten. Die im Rahmen dieser Erfindung als Diisocyanat-modifizierte Polyamide gekennzeichneten Polymere lassen sich dementsprechend auch als Polyamid-harnstoff-urethane oder Poly-urethan-harnstoff-amide bezeichnen.

Zu den Aufbaukomponenten der erfindungsgemäss einzusetzenden Diisocyanat-modifizierten Polyamide (B1) ist im einzelnen folgendes auszuführen:

Als Polyamide, die zwei im Sinne der Isocyanatchemie reaktionsfähige Wasserstoffatome tragen, kommen insbesondere die Polyamide mit 2 endständigen Aminogruppen in Betracht, wie sie durch Polykondensation von Dicarbonsäuren und Diaminen erhalten werden können. Als Dicarbonsäuren und Diamine können dabei die für Herstellungen von Polyamiden üblichen Verbindungen herangezogen werden. Bei den Dicarbonsäuren sind dabei neben den aromatischen Dicarbonsäuren, wie z.B. Terephthalsäure und Isophthalsäure, vorzugsweise insbesondere die aliphatischen Dicarbonsäuren zu nennen, wie z.B. Bernsteinsäure, Adipinsäure, Glutarsäure, Azelainsäure, Sebacinsäure oder Dodecandisäure, die allein oder im Gemisch miteinander eingesetzt werden können. Anstelle der Dicarbonsäuren können zur Herstellung der Polyamide natürlich auch die niederen Alkylester oder die Säurehalogenide dieser Dicarbonsäuren eingesetzt werden. Als Diamine, die ebenfalls allein oder im Gemisch miteinander zur Anwendung kommen können, eignen sich beispielweise gesättigte aliphatische geradkettige Diamine, z.B. Tetramethylendiamin, Pentamethylendiamin, Hexamethylendiamin, Heptamethylendiamin, Octamethylendiamin, Nonamethylendiamin oder Decamethylendiamin; sowie cycloaliphatische Diamine, wie z.B. 4,4'-Diaminodicyclohexylmethan, 3,3'-Dimethyl-4,4'-diaminodicyclohexylmethan oder 2,2-Bis-[4-aminocyclohexyl]-propan; als auch heterocyclische Diamine, wie z.B. Piperazin, 1-(2-Aminoethyl)-piperazin und N,N'-Bis-[3-amino-2,2-dimethylpropyl]-piperazin. Für die Herstellung der Polyamide eignen sich auch ω-Aminocarbonsäuren oder Lactame, wie beispielsweise ω-Aminocapronsäure, ω-Aminoheptansäure, ω-Aminocaprylsäure, ω-Aminolaurinsäure, ε-Caprolactam, α-Methyl-ε-caprolactam, ε-Methyl-ε-caprolactam und andere, sofern die endständige Carboxylgruppen der so hergestellten Polyamide anschliessend noch durch Reaktion mit einem Diamin, Diol oder Aminoalkohol umgesetzt werden.

Die Polyamide mit den zwei gegenüber Isocyanaten reaktionsfähigen Wasserstofatomen können nach bekannten Verfahren hergestellt werden. Zur Herstellung der Diisocyanat-modifizierten Polyamide (B1) können sie allein oder im Gemisch miteinander eingesetzt werden. Vorzugsweise kommen hier Polyamide aus längerkettigen Dicarbonsäuren, wie z.B. Azelainsäure und/oder Dodecandisäure, und Piperazin zum Einsatz, die bei der Herstllung durch Überschuss von Piperazin oder einem anderen Diamin mit Amino-Endgruppen versehen worden sind. Die Polyamide mit den zwei gegenüber Isocyanaten reaktionsfähigen Wasserstoffatomen werden bei der Herstellung der Diisocyanat-modifizierten Polyamide (B1) in solchen Mengen eingesetzt, dass ihr Gehalt im Diisocyanat-modifizierten Polyamid (B1) von etwa 15 bis 65 Gew.%, insbesondere von

etwa 20 bis 55 Gew.%, bezogen auf das Diisocyanat-modifizierte Polyamid, beträgt. Das Molekulargewicht der Polyamide mit den zwei gegenüber Isocyanaten reaktionsfähigen Wasserstoffatomen liegt dabei im allgemeinen im Bereich von 500 bis 10 000, vorzugsweise von 700 bis 5000, bestimmt nach der Endgruppenmethode.

Als Diisocyanate, die zur Herstellung der Diisocyanat-modifizierten Polyamide (B1) allein oder im Gemisch miteinander eingesetzt werden können, eignen sich die üblichen, aus der Polyurethanchemie bekannten Verbindungen. Es kommen dabei im Prinzip beliebige aliphatische, cycloaliphatische, araliphatische, aromatische und heterocyclische Diisocyanate in Betracht. Beispielhaft seien genannt 4,4'-Diphenylmethandiisocyanat, Dicyclohexylmethandiisocyanat, 1,5-Naphthylendiisocyanat, 2,4- und 2,6-Toluylendiisocyanat, Hexamethylendiisocyanat, Isophorondiisocyanat und Trimethylhexamethylendiisocyanat. Weitere geeignete Diisocyanate sind u.a. 4,4'-Dibenzyldiisocyanat, 1,3- und 1,4-Phenyldiisocyanat, Cyclohexan-1,4-diisocyanat, Xylylendiisocyanate, halogenierte Diisocyanate, wie z.B. 4-Chlor-1,3-phenyldiisocyanat, sowie die Hydrierungsprodukte von aromatischen Diisocyanatverbindungen, wie z.B. 1,5-Tetrahydronaphthylendiisocyanat. Die Diisocyanate werden bei der Herstellung der Diisocyanat-modifizierten Polyamide (B1) in solchen Mengen eingesetzt, dass ihr Gehalt im Diisocyanat-modifizierten Polyamid zwischen 10 und 50 Gew.%, insbesondere im Bereich von etwa 15 bis 45 Gew.%, bezogen auf das Diisocyanat-modifizierte Polyamid, liegt.

Die quaternisierbaren Stickstoffatome lassen sich in die erfindungsgemäss einzusetzenden Diisocyanat-modifizierten Polyamide (B1) einbauen, indem man bei deren Herstellung tertiäre Stickstoffatome tragende Verbindungen mitverwendet, die im Sinne der Isocyanatchemie im allgemeinen bifunktionell reaktionsfähig sein sollen. Als solche eignen sich insbesondere Diole mit tertiären Stickstoffatomen, aber auch z.B. entsprechende Diamine oder Aminoalkohole. Neben den bifunktionellen tertiären Stickstoff-Verbindungen können bei der Herstellung der Diisocyanat-modifizierten Polyamide (B1) in geringem Umfang jedoch beispielsweise auch tertiäre Stickstoffatome tragende Verbindungen mitverwendet werden, die im Sinne der Isocyanatchemie nur monofunktionell reaktionsfähig sind. Die Mitverwendung von höherfunktionellen, beispielsweise trifunktionellen tertiären Stickstoffverbindungen, ist weniger empfehlenswert, da hierdurch leicht zu stark verzweigte Produkte gebildet werden.

Als im Sinne der Isocyanatchemie bifunktionell reaktionsfähige tertiäre Stickstoff-Verbindungen werden vorteilhaft entsprechende niedermolekulare, als Kettenverlängerer wirkende Verbindungen eingesetzt. Hierbei kommen insbesondere Verbindungen der allgemeinen Formeln (I), (II) und (III)

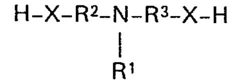
(I)

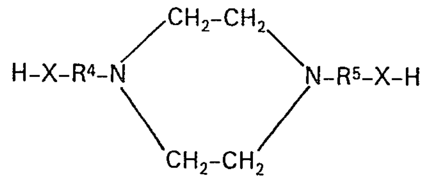
(II)

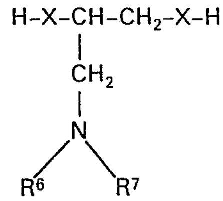
(III)

in Betracht, worin bedeuten:

X ein Sauerstoffatom, Schwefelatom oder eine -NR-Gruppe mit R = Wasserstoffatom oder einer niederen Alkylgruppe, insbesondere mit 1 bis 6 Kohlenstoffatomen;

$R^1$ eine Alkylgruppe, insbesondere mit 1 bis 6 Kohlenstoffatomen, eine Cycloalkyl- oder Aryl-Gruppe;

$R^2$–$R^5$ eine geradkettige oder verzweigte Alkylen- oder Oxalkylengruppe, insbesondere mit 1 bis 6 Kohlenstoffatomen, oder eine Cycloalkylen- oder Phenylen-Gruppe, wobei die Reste $R^2$ und $R^3$ bzw. $R^4$ und $R^5$ jeweils gleich oder verschieden sein können;

$R^6$, $R^7$ jeweils für sich eine Alkylgruppe, insbesondere mit 1 bis 6 Kohlenstoffatomen, eine Cycloalkylgruppe oder eine Arylgruppe oder $R^6$ und $R^7$ zusammen einen gegebenenfalls weitere Heteroatome enthaltenden Ring.

In den Formeln (I) und (II) ist X vorzugsweise ein Sauerstoffatom oder eine -NR-Gruppe, wobei R insbesondere eine niedere Alkylgruppe, wie z.B. eine Methyl-, Ethyl- oder Propyl-Gruppe ist. $R^1$ stellt beispielsweise eine Methyl-, Ethyl-, Propyl-, Isopropyl-, Butyl- oder Isobutyl-Gruppe dar, vorzugsweise jedoch eine Methyl- oder Ethyl-Gruppe, oder einen Cyclohexyl- oder Phenylrest. Beispiele für die Gruppen $R^2$ bis $R^5$ sind die $-CH_2$-Gruppe, $-CH_2-CH_2$-Gruppe, die $CH_2-CH_2-CH_2$-Gruppe, die $-CH(CH_3)-CH_2$-Gruppe, die $-(CH_2)_4$-Gruppe; die $-(CH_2-CH_2-O)_n-CH_2-CH_2$-Gruppe, die $-(CH(CH_3)-CH_2-O)_n-CH(CH_3)-CH_2$-Gruppe mit n = einer ganzen Zahl, insbesondere 1 oder 2; die $C_6H_{10}$-Gruppe oder die $C_6H_4$-Gruppe.

In der Formel (III) ist X vorzugsweise ein Sauerstoffatom. $R^6$ und $R^7$ stellen jeweils für sich, insbesondere eine niedere Alkylgruppe, wie z.B. die Methyl-, Ethyl- oder Propyl-Gruppe, oder einen Cyclohexylrest dar. $R^6$ und $R^7$ können zusammen auch einen vorzugsweise fünf- oder sechsgliedrigen Ring bilden, der als weitere Heteroatome insbesondere N oder O enthalten kann. Als Beispiele hierfür seien der Piperidin-Ring, der Piperazin-Ring und der Morpholin-Ring genannt.

Im einzelnen seien als tertiäre Stickstoff-Verbindungen des Typs der allgemeinen Formeln (I) und (II) genannt N-Methyldiethanolamin, N-Ethyldiethanolamin, N-Methyldiisopropanolamin, N-Ethyldiisopropanolamin, N-Propyldiethanolamin, N-Propyldiisopropanolamin, N-Isopropyldipropanolamin, N-Isopropyldiethanolamin, N,N-Bis(2-hydroxyethyl)-cyclohexylamin, N,N-Bis(2-hydroxyethyl)anilin, N,N-Bis-(2-hydroxyethyl)toluidin; N,N′-Bis(hydroxymethyl)piperazin, N,N′-Bis(hydroxymethyl)-methylpiperazin, N,N′-Bis(2-hydroxyethyl)piperazin, N,N′-Bis(2-hydroxyethyl)-2,5-dimethylpiperazin, N,N′-Bis(2-hydroxypropyl)-piperazin, N,N′-Bis-(2-hydroxy-2-methylpropyl)piperazin, N,N′-Bis-(hydroxylcyclohexyl)piperazin, N,N′-Bis(hydroxycycloheptyl)piperazin, N,N′-Bis(hydroxyphenyl)-piperazin, N,N′-Bis(diethoxy)piperazin, N,N′-Bis-(triethoxy)piperazin, N,N′-Bis(dipropoxy)-piperazin. Günstig ist auch der Einsatz von entsprechenden Diaminverbindungen, oder Aminoalkoholen, wie sie beispielsweise in der DE-A-24 54 676 angeführt sind. Stellvertretend für die Verbindungen des Typs der allgemeinen Formel (III) seien genannt 1-(N,N-Diethyl)-aminopropandiol-2,3; 1-[N,N-Di-(n-propyl)]-aminopropandiol-2,3; N-Moropholinopropandiol-2,3; N-Methyl-N′-piperazinpropandiol-2,3.

Die seitenständigen, photopolymerisierbaren Doppelbindungen können in das erfindungsgemäss einzusetzende Diisocyanat-modifizierte Polyamide (B1) eingeführt werden, indem man bei dessen Herstellung kettenverlängernde Verbindungen mitverwendet, die seitenständige olefinische Doppelbindungen aufweisen. Bei den Doppelbindungen kann es sich um einfache, nicht aktivierte Doppelbindungen handeln, wie beispielsweise die Vinyl-Gruppe; besonders günstig sind aktivierte Doppelbindungen, wie beispielsweise acrylische Doppelbindungen. Vorzugsweise sind die Doppelbindungen in der Seitengruppe endständig.

Als Beispiele für kettenverlängernde Verbindungen mit nicht aktivierten Doppelbindungen seien Buten-1-diol-3,4, Dimethylolnorbonen und 4,5-Dimethylolcyclohexen genannt. Als geeignete kettenverlängernde Verbindungen mit aktivierten Doppelbindungen kommen z.B. ungesättigte Carbonsäureesterdiole in Betracht. Hierbei kann es sich beispielsweise um Reaktionsprodukte von Dicarbonsäuren mit polymerisierbaren, olefinisch ungesättigten Glycidylverbindungen handeln. Solche Verbindungen sind z.B. in der DE-A-21 64 386 beschrieben. Es kommen jedoch in gleicher Weise auch die Reaktionsprodukte von Epoxidverbindungen mit polymerisierbaren, olefinisch ungesättigten Carbonsäuren in Betracht. Als besonders vorteilhaft haben sich Reaktionsprodukte von Epoxiden mit α,β-ungesättigten Monocarbonsäuren, insbesondere Acryl- und/oder Methacrylsäure, erwiesen. Bei den Epoxiden kann es sich um OH-Gruppen tragende Monoepoxide, wie z.B. Glycidol, handeln; es können aber auch Epoxide mit zwei endständigen Epoxidgruppen sein. Insbesondere bevorzugt sind die Reaktionsprodukte von Acryl- und/oder Methacrylsäure mit Diepoxiden entsprechend der allgemeinen Formel (IV)

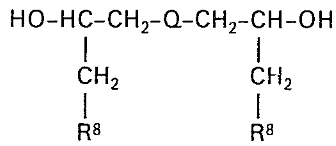
(IV)

worin bedeuten:
$R^8$ eine ($CH_2{=}CR^9$-CO-O-)-Gruppe mit $R^9$ = einem Wasserstoffatom oder einem Methyl-Rest, Q -O-; $-O-(CH_2)_m-O$; $-O-(CH_2-CH_2-O-)_n$; $-O-(CHCH_3-CH_2-O-)_p$ mit m, n und p unabhängigen ganzen Zahlen von 1 bis 10, vorzugsweise von 1 bis 7; oder ein Rest der allgemeinen Formel (V)

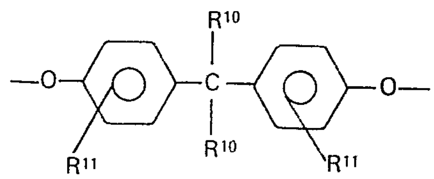
(V)

worin stehen
$R^{10}$ und $R^{11}$ für ein Wasserstoffatom oder eine Alkyl-Gruppe mit 1 bis 10 Kohlenstoffatomen, z.B. die Methyl-, Ethyl-, Propyl-, Butyl- oder Hexyl-Gruppe.

Die Umsetzung zwischen den Epoxidverbindungen und den polymerisierbaren olefinisch ungesättigten Carbonsäuren ist eine ringöffnende Veresterung zwischen den Epoxidgruppen der Diepoxyverbindungen und den Carboxylgruppen der Carbonsäuren, die etwa analog der DE-A-21 64 386 in bekannter Weise ausgeführt werden kann (vgl. auch US-A- 3 373 075 und US-A-2 824 851). Die vorgenannten Epoxidverbindungen und deren Umsetzungsprodukte können allein oder im Gemisch miteinander verwendet werden. Bevorzugt eignen sich für den Zweck der Erfindung Umsetzungsprodukte aus Bisphenol-A-Diglycidylether (z.B. ® Epikote 828 der Fa. Shell) oder 2,3-Epoxpropanol-1(Glycidol) mit Acryl- und/oder Methacrylsäure.

Die ungesättigten Carbonsäureesterdiole, insbesondere die Reaktionsprodukte von Acryl- und/oder Methacrylsäure mit Epoxidverbindungen, haben ein Molekulargewicht zwischen 146 und 3000.

Die kettenverlängernden Verbindungen mit seitenständigen olefinischen Doppelbindungen sollten für die Umsetzung mit den Diisocyanaten im wesentlichen bifunktionell sein. Ist die Funktionalität gegenüber Isocyanatgruppen grösser als 2 erfolgt gegebenenfalls eine zu starke Verzweigung des Diisocyanat-modifizierten Polyamids bzw. besteht die Gefahr einer Vernetzung.

Neben den genannten Verbindungen können bei der Herstellung der erfindungsgemäss einzusetzenden Diisocyanat-modifizierten Polyamide (B1) gegebenenfalls noch höhermolekulare Polydiole und/oder weitere niedermolekulare Diole,

Diamine oder Aminoalkohole mit Molekulargewichten zwischen 61 und 400 als Kettenverlängerungsmittel mitverwendet werden. Der Einsatz solcher zusätzlichen Verbindungen hängt einerseits ab von den gewählten Ausgangsverbindungen und dem gewünschten Molekulargewicht, andererseits auch von den angestrebten Eigenschaften des Diisocyanat-modifizierten Polyamids (B1) und des Aufzeichnungsmaterials. So führt beispielsweise der Einbau von Polyether-Segmenten, wie er z.B. aus der Mitverwendung von Polyetherdiolen resultiert, zu Weichsegmenten in den Diisocyanat-modifizierten Polyamiden (B1).

Als höhermolekulare Polydiole, die bei der Herstellung der erfindungsgemäss einzusetzenden Diisocyanat-modifizierten Polyamide (B1) mitverwendet werden können, eignen sich die bekannten, im wesentlichen linearen Polyesterdiole, Polyetherdiole, Polylacton- sowie Polycarbonatdiole. Ausser den endständigen hydroxylgruppen können die Polydiole in geringem Umfang auch noch Carboxyl-, Amino- oder Mercaptogruppen enthalten. Das Molekulargewicht der Polydiole liegt vorteilhafterweise zwischen 400 und 5000, vorzugsweise zwischen etwa 500 und 4000. Die Polydiole werden bei der Herstellung der erfindungsgemäss einzusetzenden Diisocyanat-modifizierten Polyamide (B1) im allgemeinen in solchen Mengen verwendet, dass ihr Anteil im Diisocyanat-modifizierten Polyamid (B1) kleiner oder höchstens gleich dem Anteil der Polyamide mit den zwei gegenüber Isocyanaten reaktionsfähigen Wasserstoffatomen ist. Der Gehalt an Polyamiden mit zwei gegenüber Isocyanaten reaktionsfähigen Wasserstoffatomen und den höhermolekularen Polyolen im Diisocyanat-modifizierten Polyamid (B1) soll zusammen etwa von 15 bis 65 Gew.%, insbesondere von etwa 20 bis 55 Gew.%, bezogen auf das Diisocyanat-modifizierte Polyamid, betragen.

Von den höhermolekularen Polydiolen, die allein oder im Gemisch miteinander verwendet werden können, seien beispielhaft die folgenden genannt: Geeignete Polyesterdiole sind insbesondere die gesättigten Polyesterdiole, wie z.B. Veresterungsprodukte von Dicarbonsäuren, insbesondere Adipinsäure, mit $C_2$- bis $C_{10}$-Alkandiolen oder Oxalkandiolen mit 2 bis 6 Kohlenstoffatomen. Beispielhaft seien als Polyesterdiole genannt Adipate mit Glykol (Molekulargewicht etwa 2000), mit Diethylenglykol (Molekulargewicht ca. 2000), mit Butandiol-1,4 (Molekulargewicht 940), mit Hexandiol-1,6 (Molekulargewicht 1000), mit einem Hexandiol-1,6/Butandiol-1,4-Gemisch im Verhältnis 1:1 (Molekulargewicht 1000 bzw. 2000) und 2,2-Dimethylpropandiol-1,3 (Molekulargewicht 1000). Geeignete Polycarbonatdiole sind z.B. Hexandiolpolycarbonate. Für die Polylactondiole seien stellvertretend die Polycaprolactondiole (Molekulargewicht 830 und 2000) genannt. Günstig sind insbesondere die Polyetherdiole. Als Beispiele dafür seien genannt die Polymerisationsprodukte des Ethylenoxids, Propylenoxids, Tetrahydrofurans, Butylenoxids oder deren Misch- oder Pfropfpolymerisationsprodukte sowie die durch Kondensation von mehrwertigen Alkoholen oder Mischungen derselben gewonnenen Kondensate oder die durch Alkoxylierung von mehrwertigen Alkoholen gewonnen Produkte. Besonders vorteilhaft sind z.B. Polytetrahydrofuran, Polyethylenglykol, Polypropylenglykol oder Ethylenoxid/Propylenoxid-Mischpolykondensationsprodukte, wobei der Propylenoxid-Anteil vorzugsweise 10 bis 90 Gew.% beträgt. Bevorzugt werden dabei solche Polydiole eingesetzt oder zumindest mitverwendet, die mindestens 5 Ätherbindungen enthalten.

Als weitere, niedermolekulare Kettenverlängerer können eingesetzt werden die üblichen gesättigten oder ungesättigten Glykole, wie Ethylenglykol und Kondensate des Ethylenglykols, Butandiol, Propandiol-1,2, Propandiol-1,3, Neopentylglykol, Hexandiol-1,6, Decandiol-1,10, Dioxethoxyhydrochinon, Butendiol; alkoxylierte aliphatische, cycloaliphatische, aromatische oder heterocyclische primäre und sekundäre Amine, wie beispielsweise Ethanolamin, N-Methylethanolamin, N-Butylethanolamin, N-Oleylethanolamin, N-Cyclohexylisopropanolamin, polyethoxyliertes N-Butylethanolamin; die aliphatischen, cycloaliphatischen oder aromatischen Diamine, wie Ethylendiamin, Hexamethylendiamin, Piperazin, 1,4-Cyclohexylen-diamin, Benzidin, Diamindiphenylmethan, 3,3'-Dimethyl-4,4'-diaminodicyclohexylmethan, die Isomeren des Phenylendiamins oder Hydrazins.

Die Herstellung der erfindungsgemäss einzusetzenden Diisocyanat-modifizierten Polyamide (B1) kann unter den aus der Literatur bekannten üblichen Bedingungen der Polyaddition in Masse oder in Lösung erfolgen. Die einzelnen Komponenten werden dabei im allgemeinen in einem solchen Verhältnis zueinander eingesetzt, dass das NCO/OH, NH-Molverhältnis etwa 0,8 bis 1,85, insbesondere etwa 0,9 bis 1,2, beträgt.

Zweckmässigerweise erfolgt die Herstellung der Diisocyanat-modifizierten Polyamide in Lösung. Dabei kann jedes beliebige Lösungsmittel eingesetzt werden, das mit dem Reaktionsprodukt und den Reaktionspartnern nicht in Reaktion tritt. Bevorzugte Lösungsmittel sind gegebenenfalls halogenierte Kohlenwasserstoffe, Ketone, Ether, Ester oder Nitrile, wie z.B. Aceton, Methylethylketon, Acetonitril, Ethylacetat, Methylenchlorid, Chloroform, Tetrachlorkohlenstoff, Dimethylformamid, Dimethylsulfoxid, Tetrahydrofuran, Dioxan oder t-Butanol. Selbstverständlich können auch Mischungen derartiger Lösungsmittel verwendet werden. Für die Herstellung der Diisocyanat-modifizierten Polyamide in Lösung bieten sich die für die Polyurethan-Herstellung bekannten und üblichen Ein- oder Mehrstufenverfahren an.

Die Polyaddition kann mit und ohne Katalysatoren durchgeführt werden. Geeignete Katalysatoren sind z.B. tertiäre Amine, wie etwa Triäthylendiamin; Metallsalze, wie z.B. Caliumacetat; oder organische Metallverbindungen, wie z.B. Dibutylzinndilaurat und Zinnoktoat. Diese Katalysatoren werden insbesondere in Mengen von 0,001 bis 0,5 Gew.%, bezogen auf das Polymere, zugesetzt.

Gemäss einer speziellen Ausführungsform der Erfindung werden in den photopolymerisierbaren Aufzeichnungsmaterialien als Komponente (B1) solche Diisocyanat-modifizierten Polyamide eingesetzt, die durch Umsetzung eines aliphatischen, gesättigten Polyamid-diamins mit einem aliphatischen Diisocyanat, mindestens einem niedermolekularen aliphatischen Diol, zu 25 bis 100 Mol.%, vorzugsweise zu 50 bis 100 Mol.% aus Buten-1-diol-3,4 und/oder Dimethylolnorbonen bestehend, sowie einer im Sinne der Isocyanatchemie bifunktionell reaktionsfähigen tertiären Stickstoff-Verbindung erhalten worden sind. Das aliphatische gesättigte Polyamid-diamin ist eines der oben angegebenen Art und hat vorzugsweise ein Molekulargewicht von 400 bis 4000. Das aliphatische Diisocyanat ist insbesondere Hexamethylendiisocyanat und als tertiäre Stickstoffverbindung kommen vorzugsweise N-Methyl-diethanolamin oder N,N'-Bis(2-hydroxyethyl)-piperazin in Betracht. Das Buten-1-diol-3,4 und/oder Dimethylolnorbonen wird vorzugsweise zusammen mit Buten-2-diol-1,4, 2,3-Dichlor-buten-2-diol-1,4 und/oder gesättigten aliphatischen Diolen mit einem Molekulargewicht nicht über 200 verwendet, wie z.B. im Gemisch mit Ethylenglykol, Propylenglykol, Butandiol-1,3, Butandiol-1,4 oder Neopentylglykol.

Nach einer besonders bevorzugten Ausführungsform der Erfindung werden in den photopolymerisierbaren Aufzeichnungsmaterialien als Komponente (B1) solche Diisocyanat-modifizierte Polyamide eingesetzt, die durch Umsetzung von Diisocyanaten mit Polyamid-diaminen, im Sinne der Isocyanatchemie bifunktionell reaktionsfähigen tertiären Stickstoffverbindungen, Acryl- und/oder Methacrylsäureesterdiolen sowie gegebenenfalls höhermolekularen Polydiolen und/oder weiteren niedermolekularen Diolen, Diaminen und/oder Aminoalkoholen als Kettenverlängerer hergestellt worden sind. Als Diisocanate kommen hierbei die weiter oben genannten, insbesondere die aliphatischen und cycloaliphatischen Diisocyanate in Betracht, wobei Hexamethylendiisocyanat, Isophorondiisocyanat und Dicyclohexylmethandiisocyanat unter anderem bevorzugt eingesetzt werden. Als Polyamid-Komponente werden in diesem Fall vorteilhaft Polyamid-diamine aus längerkettigen Dicarbonsäuren, wie z.B. Azelain- und Dodecandisäure, mit Piperazin und gegebenenfalls geringeren Mengen weiterer polyamidbildender Komponenten verwendet. Unter den im Sinne der Isocyanatchemie bifunktionell reaktionsfähigen tertiären Stickstoffverbindungen haben sich hier insbesondere die N-Alkyl-diethanolamine, wie N-Methyldiethanolamin und N-Ethyldiethanolamin; die N-Alkyldiisopropanolamine, wie z.B. das N-Methyldiisopropanolamin; als auch die Dihydroxyalkylenpiperazine, insbesondere das N,N'-Bis(2-hydroxyethyl)-piperazin, das N,N'-Bis-(2-hydroxylpropyl)piperazin, das N,N'-Bis(diethoxy)piperazin, das N,N'-Bis(triethoxy)piperazin und das N,N'-Bis(dipropoxy)piperazin; und Umsetzungsprodukte von sekundären Aminen mit Glycidol, wie z.B. das 1-(N,N-Diethyl)-aminopropandiol-2,3, als vorteilhaft erwiesen. Von den Acryl- und/oder Methacrylsäureesterdiolen haben die der oben angegebenen allgemeinen Formel (IV) besondere Bedeutung, wobei wiederum diejenigen, in denen der Rest Q der allgemeinen Formel (V) entspricht, bevorzugt sind. Wie bereits weiter oben erwähnt, sind dabei die Umsetzungsprodukte aus Bisphenol-A-diglycidylether (z.B. ® Epikote 828 der Fa. Shell), 2,3-Epoxpropanol-1 (Glycidol) oder aliphatischen Diepoxyden, wie Butandioldiglycidylether, mit Acryl- und/oder Methacrylsäure besonders bevorzugt. Als gegebenenfalls mitzuverwendende höhermolekulare Polydiole kommen in diesem Fall vorteilhaft die Polyetherdiole, insbesondere Polyethylenglykol, Polypropylenglykol, Ethylenoxid-/Propylenoxid-Mischpolykondensationsprodukte und Polytetrahydrofuran, in Betracht. Die Diisocyanat-modifizierten Polyamide können, wie bereits erwähnt, vor ihrem Einsatz in den photopolymerisierbaren Aufzeichnungsmaterialien ganz oder teilweise quaternisiert werden. Sie können allein oder im Gemisch miteinander verwendet werden. Die photopolymerisierbare Schicht B der photopolymerisierbaren Aufzeichnungsmaterialien kann dabei in der Komponente (B1) neben den erfindungsgemäss einzusetzenden, vorgehend beschriebenen Diisocyanat-modifizierten Polyamiden auch noch weiter übliche polymere Bindemittel, die mit den in Rede stehenden Diisocyanat-modifizierten Polyamiden verträglich sind, enthalten. Als solche weiteren Bindemittel, die neben den erfindungsgemäss einzusetzenden Diisocyanat-modifizierten Polyamiden in der photopolymerisierbaren Schicht B enthalten sein können, kommen beispielsweise andere Polyamide, Polyurethane und gegebenenfalls modifizierte Polyvinylalkohole bzw. Vinylalkoholpolymerisate in Betracht. Der Anteil der erfindungsgemäss einzusetzenden Diisocyanat-modifizierten Polyamide soll 60 bis 100 Gew.%, bezogen auf das gesamte Bindemittel (Komponente B1), betragen. Bevorzugt werden die erfindungsgemäss einzusetzenden Diisocyanat-modifizierten Polyamide als einziges Bindemittel in der photopolymerisierbaren Schicht B der Aufzeichnungsmaterialien eingesetzt.

Die photopolymerisierbare Schicht B der Aufzeichnungsmaterialien enthält neben dem polymeren Bindemittel (Komponente B1) als weitere Bestandteile mindestens eine weitere photopolymerisierbare, ethylenisch ungesättigte Verbindung (Komponente B2), mindestens einen Photopolymerisationsinitiator (Komponente B3) sowie gegebenenfalls sonstige übliche Zusatzstoffe (Komponente B4).

Als weitere photopolymerisierbare, ehtylenisch ungesättigte Verbindungen (Komponente B2) kommen die an sich bekannten niedermolekularen Monomeren und/oder Oligomeren (mit einem Molekulargewicht bis zu 5000, vorzugsweise mit einem Molekulargewicht bis zu 2000) in Frage, die für photopolymerisierbare Aufzeichnungsmaterialien der in Rede stehenden Art üblich und gebräuchlich sind. Die photopolymerisierbaren, ethylenisch ungesättigten Verbindungen (Komponente B2) sollen dabei – für den Fachmann selbstverständlich – mit dem polymeren Bindemittel (Komponente B1) verträglich sein und im allgemeinen einen Siedepunkt von über 100°C bei Atmosphärendruck aufweisen. Die photopolymerisierbaren, ethylenisch ungesättigten Verbindungen (Komponennte B2) können monofunktionell oder mehrfunktionell sein, d.h. sie können eine oder mehrere der photoinitiierten Polymerisationsreaktion zugängliche C-C-Doppelbindungen besitzen. Die photopolymerisierbaren, ethylenisch ungesättigten Verbindungen (Komponente B2) können dabei alleine als auch in Mischung miteinander eingesetzt werden. Beispielsweise können ein oder mehrere monofunktionelle Verbindungen bzw. ein oder mehrere mehrfunktionelle Verbindungen dieser Art in dem photopolymerisierbaren Aufzeichnungsmaterial enthalten sein; in bestimmten Anwendungsfällen sind als Komponente (B2) Kombinationen von mono- und mehrfunktionellen, insbesondere Kombinationen von mono- und bifunktionellen photopolymerisierbaren, ethylenisch ungesättigten Verbindungen von Vorteil. Die Art als auch die Menge der eingesetzten photopolymerisierbaren, ethylenisch ungesättigten Verbindungen (Komponente B2) richtet sich natürlich nach dem mitverwendeten polymeren Bindemittel (Komponente B1) und insbesondere nach Art und Anwendungszweck des photopolymerisierbaren Aufzeichnungsmaterials, d.h. nach dessen angestrebtem Eigenschaftsbild. So sind beispielsweise für die Herstellung von Reliefdruckplatten für den Zeitungs- und Akzidenzdruck mehrfunktionelle, schnell vernetzende photopolymerisierbare, ethylenisch ungesättigte Verbindungen als Komponente (B2) von Vorteil.

Das Mengenverhältnis von polymerem Bindemittel (Komponente B1) zu den weiteren photopolymerisierbaren, ethylenisch ungesättigten Verbindungen (Komponente B2) in der photopolymerisierbaren Schicht B ist in weitem Umfang variierbar. Es beträgt im allgemeinen etwa 97 bis 40 Gew.% an polymerem Bindemittel (Komponente B1) zu 3 bis 60 Gew.% an photopolymerisierbaren, ethylenisch ungesättigten Verbindungen (Komponente B2). Vorzugsweise liegt das Verhältnis der Komponenten (B1) und (B2) in der photopolymerisierbaren Schicht B bei etwa 95 bis 60 Gew.% an polymerem Bindemittel (Komponente B1) zu 5 bis 40 Gew.% an photopolymerisierbaren, ethylenisch ungesättigten Verbindungen (Komponente B2), wobei diese Angaben jeweils auf die Summe der Komponenten (B1) und (B2) bezogen sind. Werden als Komponente (B2) Mischungen aus monofunktionellen und mehrfunktionellen photopolymerisierbaren, ethylenisch ungesättigten Verbindungen eingesetzt, so liegt der Anteil der monofunktionellen photopolymerisierbaren, ethylenisch ungesättigten Verbindungen hierin im allgemeinen im Bereich von 5 bis 70 Gew.%, bezogen auf die Komponente (B2).

Geeignete photopolymerisierbare, ethylenisch ungesättigte Verbindungen, die als Komponente (B2) in den erfindungsgemässen photopolymerisierbaren Aufzeichnungsmaterialien eingesetzt werden können, sind unter anderem beispielsweise in den US-Patentschriften 2 760 863 und 3 060 203 beschrieben. So eignen sich Allylester von Carbonsäuren, wie Allylacrylat oder Diallylphthalat; Vinylester aliphatischer Monocarbonsäuren, wie z.B. Vinylacetat, Vinylbutyrat oder Vinyloleat; Vinylether von Alkoholen, wie Octadecylvinylether oder Butandiol-1,4-divinylether. Vorteilhaft sind Derivate, z.B. Ester oder Amide, von ungesättigten Carbonsäuren, wie beispielsweise Derivate von Maleinsäure und insbesondere Derivate der Acryl- oder Methacrylsäure. Als Beispiel für Maleinsäure-Derivate seien die Maleinsäuredialkylester mit 1 bis 4 Kohlenstoffatomen in der Alkohol-Komponente genannt. Besonders bevorzugt sind die monofunktionellen und mehrfunktionellen Derivate der Acrylsäure und Methacrylsäure. Hierzu gehören insbesondere, neben Acrylsäure und Methacrylsäure selber, Acrylamid und Methacrylamid; die N-Hydroxyalkyl(meth)acrylamide mit 1 bis 6 Kohlenstoffatomen in der Alkyl-Gruppe, wie z.B. N-Hydroxymethyl-(meth)-acrylamid oder N-Hydroxyethyl-(meth)-acrylamid; Derivate und Umsetzungsprodukte dieser (Meth)-Acrylamide sowie auch die Ester der Acrylsäure und Methacrylsäure von Monoalkoholen, Dialkoholen oder Polyalkoholen. Als Vertreter der Acrylate und Methacrylate seien im einzelnen genannt: (Meth)-Acrylate von Alkanolen mit 1 bis 6 Kohlenstoffatomen z.B. Methyl-(meth)-acrylat, Ethyl-(meth)-acrylat, Propyl-(meth)-acrylat, Butyl-(meth)-acrylat, Hexylmethacrylat; die Di- und Polyacrylate und -methacrylate, wie sie durch Veresterung von Diolen oder Polyolen mit Acrylsäure oder Methacrylsäure hergestellt werden können, wie z.B. die Di- bzw. Tri-(meth)-acrylate von Ethylenglykol, Diethylenglykol, Triethylenglykol, Polyethylenglykol mit einem Molekulargewicht bis etwa 500, 1,2-Propandiol, 1,3-Propandiol, Neopentylglykol(2,2-Dimethyl-propandiol), 1,4-Butandiol, 1,1,1-Trimethylolpropan, Glycerin oder Pentaerythrit; ferner die Monoacrylate und Monomethacrylate solcher Diole und Polyole, wie z.B. die Monoacrylate und Monomethacrylate des Ethylenglykols, des Di-, Tri- oder Tetraethylenglykols. Geeignet sind auch niedermolekulare, präpolymere Urethanacrylate, wie sie z.B. durch Umsetzung von Hydroxyalkyl-(meth)acrylaten (z.B. β-Hydroxyethyl-(meth)acrylat, β-Hydroxypropyl-(meth)acrylat, Butandiol-mono-(meth)acrylat), aliphatischen Diolen (z.B. der vorstehend genannten Art) und organischen Diisocyanaten (z.B. Hexamethylendiisocyanat oder Isophorondiisocyanat hergestellt werden können. Solche niedermolekularen, präpolymeren Urethanacrylate, die vorzugsweise ein Molekulargewicht unter 5000, insbesondere zwischen

500 und 3000 besitzen, sind beispielsweise in der DE-A- 16 44 797 beschrieben. Für die Herstellung von in Wasser oder wässrigen Medien entwickelbaren Aufzeichnungsmaterialien sind besonders die wasserlöslichen Monomeren und/oder Oligomeren bevorzugt.

Als Photopolymerisationsinitiatoren (Komponente B3) kommen die bekannten und üblichen Verbindungen und Systeme für die Auslösung einer Photopolymerisationsreaktion bei Bestrahlung mit aktinischem Licht in Frage, wie sie hinreichend in der einschlägigen Fachliteratur beschrieben sind. Dabei werden solche Initiatoren bevorzugt, die unterhalb von 120°C, vorzugsweise unterhalb von 185°C thermisch inaktiv sind. Sie sollten in der photopolymerisierbaren Schicht B in dem Masse dispergierbar sein, welches zur Auslösung der gewünschten Polymerisation oder Vernetzung unter dem Einfluss der aktinischen Strahlung notwendig ist.

Genannt seien als Photoinitiatoren z.B. Acyloine und deren Derivate, wie Benzoin, Benzoinalkylether, α-Methylolbenzoin und dessen Ether, α-Methylbenzoin; vicinale Diketone und deren Derivate, wie z.B. Diacetyl, Benzil, Benzilketale, wie Benzildimethylketal, Benzilmethylethylketal, Benzilmethylbenzylketal, Benzilmethylallylketal oder Benzilethylenglykol-Monoketal; unsubstituierte und substituierte Chinone, wie Anthrachinon, Benzanthrachinon; Benzophenon und 4,4'-Bis-(dimethylamino)-benzophenon; und insbesondere Acylphosphinoxid-Verbindungen des Typs, wie sie z.B. in der DE-A- 29 09 992 beschrieben sind.

Die Photopolymerisationsinitiatoren können alleine oder im Gemisch miteinander verwendet werden. Die Photoinitiatoren werden dabei in für die Initiierung der Photopolymerisation wirksamen Mengen eingesetzt. Je nach Extinktionskoeffizient des Initiators, Schichtdicke des Aufzeichnungsmaterials etc. beträgt die Menge des eingesetzten Photopolymerisationsinitiators im allgemeinen 0,02 bis 5 Gew.%, vorzugsweise 0,1 bis 3 Gew.%, bezogen auf die Summe aller Komponenten der photopolymerisierbaren Schicht B. Die Photopolymerisationsinitiatoren können auch in Verbindung mit anderen Coinitiatoren oder Aktivatoren verwendet werden. So können beispielsweise Initiator-Systeme aus Benzoinmethylether und Triphenylphosphin; 4,4'-Bis-(dimethylamino)-benzophenon und einem halogenierten Kohlenwasserstoff (vgl. DE-A- 27 59 164); oder den Acylphosphinoxid-Verbindungen und tertiären Aminen wie Methyldiethanolamin, Dimethylethanolamin oder Triethanolamin (vgl. DE-A- 29 09 992) verwendet werden. Für solche Initiator-Systeme liegt die Gesamtkonzentration (Photoinitiator + Aktivator) bei 0,05 bis 8 Gew.%, vorzugsweise 0,5 bis 5 Gew.%, bezogen auf die photopolymerisierbare Schicht B.

Neben dem polymeren Bindemittel (Komponente B1), den weiteren photopolymerisierbaren, ethylenisch ungesättigten Verbindungen (Komponente B2) sowie den Photopolymerisationsinitiatoren (Komponente B3) können in der photopolymerisierbaren Schicht B der erfindungsgemässen Aufzeichnungsmaterialien als zusätzliche Komponente (B4) gegebenenfalls noch die üblichen Zusatzstoffe in üblichen Mengen enthalten sein. Hierzu gehören insbesondere thermische Polymerisationsinhibitoren, anorganische oder organische Pigmente oder Farbstoffe, anorganische oder organische Füllstoffe, Weichmacher, Mattierungs- oder Gleitmittel, etc.

Geeignete Polymerisationsinhibitoren sind die üblichen zur Verhinderung einer thermischen Polymerisation verwendeten Verbindungen, beispielsweise Hydrochinon, p-Methoxyphenol, p-Chinon, Kupfer-I-chlorid, Methylenblau, β-Naphthol, Phenole, m-Dinitrobenzol, N-Nitrosoamine wie N-Nitrosodiphenylamin, Phenothiazine, Phosphorigsäureester wie Triphenylphosphit, oder die Salze des N-Nitroso-cyclohexyl-hydroxylamins. Voraussetzung für die Auswahl derartiger Inhibitoren ist das Fehlen einer nennenswerten Eigenabsorption in dem aktinischen Bereich, in dem der gleichzeitig verwendete Photoinitiator absorbiert. Die Polymerisationsinhibitoren werden im allgemeinen in Mengen von 0,001 bis 2,0 Gew.%, vorzugsweise in Mengen von 0,005 bis 0,5 Gew.%, bezogen auf die Summe aller Komponenten der photopolymerisierbaren Schicht B, eingesetzt.

Zur Steuerung der Belichtungseigenschaften der erfindungsgemässen Aufzeichnungsmaterialien können in der photopolymerisierbaren Schicht B ferner Farbstoffe oder photochrome Zusätze enthalten sein. Der Zusatz von Farbstoffen oder Pigmenten kann auch der Identifizierung oder esthetischen Zwecken dienen, vorausgesetzt, dass die Farbstoffe die aktinische Strahlung nicht stark absorbieren und die Photopolymerisationsreaktion nicht stören.

Die photopolymerisierbare Schicht B kann darüberhinaus gegebenenfalls auch noch weitere Zusätze, wie z.B. verträgliche Weichmacher, Wachse, gesättigte niedermolekulare Verbindungen mit Amidgruppen etc., enthalten, mit deren Hilfe bestimmte, vom jeweiligen Anwendungsgebiet abhängige, spezielle Eigenschaften eingestellt und verbessert werden können. Beispielsweise ergibt ein Zusatz von Weichmachern in der photopolymerisierbaren Schicht B in bestimmten Mengen weichelastische Schichten mit gutem Rückstellverhalten, so dass sich der Zusatz von Weichmachern insbesondere bei photopolymerisierbaren Aufzeichnungsmaterialien empfiehlt, die beispielsweise für die Herstellung von weichelastischen Reliefdruck-Platten oder auch von Photoresists eingesetzt werden sollen. Durch Zusatz von anderen Stoffen, wie z.B. bestimmten Polymeren oder Füllstoffen, kann entsprechend die Härte der belichteten Schichten erhöht werden. Als Weichmacher kommen die hierfür bekannten Verbindungen in Betracht, wie beispielsweise Phthalsäureester, Paraffinöle oder flüssige Polybutadien-Verbindungen. Weichmacher können in der photopolymerisierbaren Schicht B im allgemeinen in Mengen von 5 bis 50 Gew.%, bezogen auf die Summe aller Komponenten der photopolymerisierbaren Schicht B, enthalten sein.

Die Beständigkeit der photopolymerisierbaren Aufzeichnungsmaterialien gegenüber Sauerstoff und Ozon kann – falls notwendig – verbessert werden, indem der photopolymerisierbaren Schicht B verträgliche bekannte Antioxidantien und/oder Ozonschutzmittel in geeigneter Menge zugesetzt werden.

Als Schichtträger A für die erfindungsgemässen photopolymerisierbaren Aufzeichnungsmaterialien eignen sich die an sich bekannten und üblichen Trägermaterialien mit hinreichend hoher Dimensionsstabilität. Hierzu gehören Metallplatten oder -folien, beispielsweise aus Stahlblech, Aluminiumblech, Kupfer oder dgl., sowie Folien aus Hochpolymeren, wie z.B. Folien aus Polyethylenterephthalat, Polybutylenterephthalat, Polyamid oder Polycarbonat. Die Auswahl der Schichtträger A ist dabei nicht auf Platten oder Folien begrenzt, ebenso können Gewebe oder Vliese, wie Glasfasergewebe, als Trägermaterialien dienen. Die Auswahl des geeigneten Trägermaterials für den Schichtträger A hängt insbesondere von dem Anwendungszweck des photopolymerisierbaren Aufzeichnungsmaterials ab. So werden für die Herstellung beispielsweise von Photoresists vorzugsweise solche Trägermaterialien verwendet, die insbesondere leicht ätzbar oder galvanisierbar sind. Für die Herstellung von Reliefdruck-Platten werden als Schichtträger im allgemeinen Metall- oder Kunststoff-Folien herangezogen.

Die Herstellung der erfindungsgemässen photopolymerisierbaren Aufzeichnungsmaterialien erfolgt in an sich bekannter Weise durch Herstellen und Verbinden der einzelnen Schichten. Zur Herstellung der photopolymerisierbaren Schicht B werden die einzelnen Komponenten (B1), (B2), (B3) sowie gegebenenfalls (B4) nach bekannten Verfahren homogen miteinander vermischt und zu Schichten gewünschter Schichtdicke verarbeitet. Die homogenen, im wesentlichen nicht lichtstreuenden Gemische aus den einzelnen Komponenten der Schicht B können nach üblichen Knet-, Misch- und Lösungsverfahren hergestellt werden. Die photopolymerisierbaren Schichten B können dann beispielsweise aus Lösungen der Gemische in geeigneten Lösungsmitteln (beispielsweise Tetrahydrofuran) durch Giessen auf die entsprechenden Schichtträger erzeugt werden. Ebenso können die photopolymerisierbaren Schichten B durch Pressen, Kalandrieren oder Extrudieren der Gemische hergestellt werden, wobei bei geeigneter Wahl der Inhibitoren keine thermische Anpolymerisation zu befürchten ist.

Die Gemische der Komponenten der Schicht B sowie die daraus hergestellten photopolymerisierbaren Schichten zeichnen sich aufgrund der erfindungsgemäss einzusetzenden Diisocyanatmodifizierten Polyamide (Komponente B1) durch eine leichte Handhabbarkeit und sehr gute Verarbeitbarkeit aus.

Zur Herstellung der photopolymerisierbaren Aufzeichnungsmaterialien können entweder vorgefertigte photopolymerisierbare Schichten B auf den Schichtträger A kaschiert oder aufgepresst werden, oder es kann, wie erwähnt, ein Gemisch der Komponenten, die die photopolymerisierbare Schicht B bilden, in geeigneter Weise, beispielsweise durch Giessen aus einer Lösung, auf den Schichtträger A aufgebracht und hier zu der photopolymerisierbaren Schicht B mit der gewünschten Schichtstärke geformt werden.

In Abhängigkeit von den eingesetzten Materialien kann es dabei zweckmässig und notwendig sein, die photopolymerisierbare Schicht B auf dem Schichtträger A mittels einer Haftschicht fest zu verankern. Diese Haftschicht kann als Zwischenlack in einer Schichtdicke von etwa 0,5 bis 40 µm verwendet werden. Als Haftschichten können z.B. handelsübliche Ein- oder Zweikomponentenkleber verwendet werden, deren Art sich nach dem Schichtträgermaterial und nach den aufgebrachten Materialien der photopolymerisierbaren Schicht B richtet. Als häufig geeignete Kleber seien die handelsüblichen Reaktionskleber auf Polyurethan- und auf Polychloropren-Basis genannt, die durch Substrieren oder Giessen in geeigneter Schichtdicke auf die zu verbindenden Schichten aufgebracht werden können.

Es ist oft von Vorteil, wenn bei den photopolymerisierbaren Aufzeichnungsmaterialien auf der dem Schichtträger abgewandten Oberfläche der photopolymerisierbaren Schicht B noch eine haftfest verbundene, dünne, klebfreie Deckschicht C aufgebracht ist. Eine solche haftfest verbundene Deckschicht C besteht bevorzugt aus harte, klebfreie, transparente und reissfeste Filme bildenden Polymeren. Da die Belichtung des photopolymerisierbaren Aufzeichnungsmaterials in diesen Fällen durch die Deckschicht C hindurch erfolgt und die Schicht C erst beim anschliessenden Entwickeln durch Abwaschen mit dem Entwickler-Lösungsmittel entfernt wird, soll die Deckschicht C aus solchen Polymeren bestehen, die im Entwickler-Lösungsmittel löslich sind. Da die photopolymerisierbare Schicht B der erfindungsgemässen Aufzeichnungsmaterialien nach der Belichtung vorteilhaft mit Wasser oder wässrigen Medien ausgewaschen wird, soll die Deckschicht C, deren Stärke je nach Anwendungsbereich der Aufzeichnungsmaterialien im allgemeinen zwischen etwa 0,1 bis 20 µm, zweckmässigerweise zwischen etwa 0,5 bis 5 µm liegt, ebenfalls hierin löslich sein. Als Beispiel für Polymere, die für die Herstellung der Deckschicht C in Betracht kommen, seien genannt: lösliche Polyamide und Copolyamide, Polyurethane, Polyvinylalkohol oder dessen Partialester, -ether oder -acetale, Gelatine, Polyvinylpyrrolidone, Polyethylenoxide mit Molekulargewichten über 100 000 und andere. Durch die haftfest verbundene Deckschicht C ist z.B. eine klebfreie, blasenfreie Negativauflage bei der Belichtung möglich; ferner wird der Zutritt von die Photopolymerisation

inhibierendem Sauerstoff zu der photopolymerisierbaren Schicht B verhindert.

Es ist ferner oft vorteilhaft, die photopolymerisierbaren Aufzeichnungsmaterialien mit einer abziehbaren Deckfolie zu versehen, wobei diese direkt auf die photopolymerisierbare Schicht B aufgebracht sein oder zusammen mit der oben erwähnten haftfest verbundenen Deckschicht C verwendet werden kann. Die Deckfolie, die beispielsweise aus Polyamid oder einem Polyester, wie Polyethylenterephthalat oder Polybutylenterephthalat bestehen kann, und die vorteilhafterweise eine Schichtstärke im Bereich von etwa 20 bis 100 µm besitzt, wird im allgemeinen vor der bildmässigen Belichtung der Aufzeichnungsmaterialien abgezogen; bei hinreichender Transparenz der Deckschicht kann die Belichtung jedoch auch durch diese hindurch erfolgen wobei die Deckschicht dann vor der Entwicklung abgezogen wird.

Die photopolymerisierbaren Aufzeichnungsmaterialien zeichnen sich aufgrund der erfindungsgemäss einzusetzenden Bindemittel aus Diisocyanat-modifizierten Polyamiden (Komponente B1) neben einer leichten Verarbeitbarkeit durch eine gute Handhabbarkeit aus. Sie haben eine herabgesetzte Haut- und Kontaktgiftigkeit; sie sind vergleichsweise thermostabil und auch über längere Zeiträume gut lagerfähig, ohne dass nachteilige Veränderungen, wie z.B. durch Alterung, Versprödung oder Kaltfluss, in merklichem Masse in Kauf genommen werden müssen. Die photopolymerisierbaren Aufzeichnungsmaterialien der Erfindung besitzen sehr gute Belichtungseigenschaften, d.h. sie sind leicht und schnell vernetzbar, und sie besitzen einen positiven Belichtungsspielraum. Wegen der guten mechanischen Eigenschaften der in der Komponente (B1) erfindungsgemäss einzusetzenden Diisocyanat-modifizierten Polyamide lassen sich mit den erfindungsgemässen photopolymerisierbaren Aufzeichnungsmaterialien leicht Druckplatten mit dem jeweils gewünschten Eigenschaftsniveau herstellen. So lassen sich beispielsweise leicht photopolymerisierbare Aufzeichnungsmaterialien herstellen, deren Schicht B nach der Belichtung eine Shore A-Härte (DIN 53 505) von 55 bis 99 besitzt, wie es beispielsweise für die Herstellung von Reliefdruckplatten erstrebenswert ist.

Die photopolymerisierbaren Aufzeichnungsmaterialien der Erfindung eignen sich insbesondere zur photochemischen Informationsfixierung durch bildmässiges Belichten der photopolymerisierbaren Schicht B und anschliessendes Entfernen der unbelichteten, unvernetzten Schichtanteile, insbesondere durch Auswaschen mit einem Entwicklerlösungsmittel in an sich bekannter Weise. Die Schichtstärke der photopolymerisierbaren Schicht B und der spezielle Aufbau der photopolymerisierbaren Aufzeichnungsmaterialien richten sich dabei nach dem speziellen Anwendungszweck. Während die Schichtstärke der photopolymerisierbaren Schicht B im allgemeinen leicht zwischen 0,005 und 6,5 mm Dicke variiert werden kann, werden beispielsweise bei der Herstellung von Photoresists Schichtdicken von 10 bis 50 µm verwendet. Für die Herstellung von Reliefdruckplatten beträgt die Schichtstärke der photopolymerisierbaren Schicht B im allgemeinen von einigen 100 µm bis zu einigen mm Dicke. Zur Herstellung von Druckplatten mit reliefbildenden Schichten von 3,0 mm bis 6,5 mm kann beispielsweise die photopolymerisierbare Schicht B auch aus Einzelschichten von photopolymerisierbaren Gemischen, gegebenenfalls unter Verwendung von anlösenden Lösungsmitteln zusammenlaminiert werden. Dabei können zur Erzielung besonderer Druckeigenschaften Schichten unterschiedlicher Härte und Rezeptur verwendet werden.

Die Belichtung der photopolymerisierbaren Aufzeichnungsmaterialien kann in Form einer Flach- oder Rundbelichtung erfolgen. Als Strahlungsquellen für das die Photopolymerisation bzw. Photovernetzung auslösende Licht können die handelsüblichen Lichtquellen von aktinischem Licht verwendet werden, wie beispielsweise UV-Fluoreszenzröhren, Quecksilbermitteldruckstrahler, aber auch Quecksilberhoch- oder -niederdruckstrahler, sowie superaktinische Leuchtstoffröhren, Xenon-Impulslampen, Metalliodid-dotierte Lampen, Kohlebogenlampen etc. Die Strahlungsquellen sollen ein Licht einer Wellenlänge zwischen 230 und 450 nm aussenden. Die emittierte Wellenlänge sollte bevorzugt bei 300 bis 420 nm liegen und ist vorzugsweise auf die Eigenabsorption des in der photopolymerisierbaren Schicht B enthaltenen Photoinitiators abgetimmt.

Als Entwickler-Lösungsmittel für das Auswaschen der unbelichteten, unvernetzten Anteile der Schicht B nach der bildmässigen Belichtung der Aufzeichnungsmaterialien können organische Lösungsmittel, wie beispielsweise Ketone, Dimethylformamid, N-Methylpyrrolidon etc., eingesetzt werden. Vorzugsweise werden zur Entwicklung der Platten jedoch Wasser oder wässrige Medien verwendet. Unter wässrigen Medien sollen dabei ganz allgemein sowohl wässrige Lösungen verstanden werden, als auch Gemische von Wasser mit den oben genannten organischen Lösungsmitteln, die nicht entflammbar und die ohne besondere Schutzvorkehrungen handhabbar sind. Wässrige Lösungen können dabei beispielsweise Protonierungsmittel, wie beispielsweise Salzsäure, Schwefelsäure, Ameisensäure oder Essigsäure, enthalten, um die Auswaschgeschwindigkeit zu erhöhen, sofern das Diisocyanat-modifizierte Polyamid (Komponente B1) noch quarternisierbare Stickstoffatome enthält. Zu den Gemischen aus Wasser und organischen Lösungsmitteln, die unter den oben erläuterten Begriff «wässrige Medien» fallen, gehören beispielsweise Alkohol/Wasser-Gemische, die bis zu 90 Vol.% Alkohol enthalten. Als Alkohole kommen hier z.B. Methanol, Ethanol und Isopropanol in Betracht.

Nach dem Auswaschen mit dem Entwicklungs-Lösungsmittel werden die resultierenden Reliefformen, z.b. Reliefdruckformen oder Photoresists, in üblicher Weise, vorteilhaft bei Temperaturen bis zu 80°C, getrocknet. In manchen Fällen ist es zweckmässig, die erhaltenen Reliefformen anschliessend nochmals mit aktinischem Licht nachzubelichten, um die Festigkeit der Formen bzw. Druckplatten zu erhöhen.

Die gemäss der Erfindung hergestellten Druckformen können für alle Arten von Druckverfahren verwendet werden. Besonders vorteilhaft sind die erfindungsgemässen Aufzeichnungsmaterialien für die Herstellung von Reliefdruckformen, wie sie insbesondere beim Zeitungs- und Akzidenzdruck Anwendung finden. In diesen Fällen besitzt die photopolymere, reliefbildende Schicht B nach der Belichtung zweckmässigerweise eine Shore A-Härte (DIN 53 505) von 55 bis 99, vorzugsweise von 60 bis 95.

Zur Herstellung von Photoresists mittels der erfindungsgemässen photopolymerisierbaren Aufzeichnungsmaterialien kann auch das Schichtübertragungsverfahren, wie es beispielsweise in der DE-B- 15 22 515 und der DE-B- 21 23 702 beschrieben wird, angewandt werden. Die Photoresists eignen sich in bekannter Weise zur galvanischen oder stromlosen Metallablagerung, zum Ätzen und für die Gravur, z.B. bei der Herstellung von gedruckten Schaltungen, integrierten Schaltkreisen, Siebdruckschablonen und anderem.

Ein unerwarteter grosser Vorteil der erfindungsgemässen Aufzeichnungsmaterialien liegt darin, dass sie neben ihren guten Eigenschaften im unbelichteten Zustand und bei der Belichtung auch im belichteten Zustand nach der Entwicklung ausgezeichnete Eigenschaften aufweisen. So können bei ihrer Verarbeitung zu Reliefdruckformen verbesserte Reliefstrukturen erhalten werden, was z.B. beim Druck zu einer deutlich verbesserten Wiedergabe von Negativschriften führt. Überraschend ist auch das hohe Auflösungsvermögen, welches eine exakte Tonwertübertragung ermöglicht. Aus den erfindungsgemässen Aufzeichnungsmaterialien hergestellte Reliefdruckplatten haben gute Farbaufnahme- und -abgabeeigenschaften und zeigen nur ein geringes Quellvermögen gegenüber den für die Druckfarben eingesetzten Lösungsmitteln. Neben ihren anderen vorteilhaften mechanischen Eigenschaften besitzen sie eine hohe Abriebfestigkeit, wodurch grosse Auflagenhöhen mit einer Druckplatte erreicht werden können. Die Druckplatten besitzen ebenfalls eine hohe Wiederverwendbarkeit.

Die folgenden Beispiele sollen die vorliegende Erfindung weiter erläutern. Die in den Beispielen genannten Teile und Prozente beziehen sich, soweit nicht anders angegeben, auf das Gewicht. Volumenteile verhalten sich zu Teilen wie Liter zu Kilogramm. Die angegebenen Viskositäten wurden unter den jeweiligen Versuchsbedingungen bestimmt. Die K-Werte wurden 1%ig in Dimethylformamid gemessen.

Beispiel

a) Herstellung des Diisocyanat-modifizierten Polyamids:

438 g einer 68,9%igen acetonischen Lösung des Diacrylats des Bisphenol-A-diglycidylethers (®Epikote 828 der Fa. Shell) werden mit 100 g Methylpiperazin in 266 g Tetrahydrofuran 8 Stunden bei 50°C gerührt. 359 g dieses Reaktionsproduktes werden mit 100 g eines Polyesters (OH-Zahl 56) bestehend aus Polycarbonat und Butandiol-1,4, mit 104 g Isophorondiisocyanat und 204 g Aceton solange bei 50°C gerührt, bis der NCO-Gehalt 1,3% beträgt. Sodann werden 93,3 g eines Copolyamids mit endständigen Amingruppen bestehend aus Dodecandicarbonsäure, Azelainsäure, Piperazin und AH-Salz als 30%ige Lösung in tert.-Butanol zugegeben. Nach Beendigung der thermischen Reaktion wird solange 4,4'-Diamino-3,3'-dimethyl-di-cyclohexylmethan zugetropft, bis die Viskosität ca. 200 mPas/50°C beträgt. Danach werden 25 g Methanol und 60 g Essigsäure zugegeben. Das erhaltene Produkt hatte einen K-Wert von 36.

b) Herstellung einer Druckplatte

100 Teile einer 35%igen wässrigen, essigsauren Lösung (pH=5) des Diisocyanat-modifizierten Polyamids werden mit 25 Teilen Bis-N-methylolacrylamidäthylenglykolether, 1,5 Teilen Benzoinmethylether und 0,3 Teil Hydrochionon versetzt. Die erhaltene Lösung wird auf eine Metallplatte oder Polyesterfolie gegossen und das Lösungsmittel abgedampft. Dabei erhält man eine 0,7 mm dicke, transparente lichtempfindliche Schicht. Auf diese Schicht wird ein Negativfilm gelegt und mit einem UV-Röhrenbelichter für photopolymere Druckplatten 5 Minuten belichtet. Nach Entfernen des Negativfilms wird das Material mit neutralem Wasser in einem Sprühwascher ausgewaschen und anschliessend getrocknet. Dabei wird eine Reliefdruckform erhalten, die sich durch hervorragende Druckfähigkeit auszeichnet.

**Patentansprüche**

1. Photopolymerisierbares Aufzeichnungsmaterial mit einem Schichtträger A, einer photopolymerisierbaren Schicht B sowie gegebenenfalls einer Deckschicht und/oder Deckfolie C, bei dem die photopolymerisierbare Schicht B enthält

1. als polymeres Bindemittel ein im wesentlichen lineares, bei Raumtemperatur festes, hochmolekulares, thermoplastisches Polymer mit eingebauten quaternären und/oder quaternisierbaren Stickstoff-Atomen,
2. mindestens eine weitere photopolymerisierbare, ethylenisch ungesättigte Verbindung,
3. einen Photopolymerisationsinitiator sowie
4. gegebenenfalls sonstige übliche Zusatzstoffe,

dadurch gekennzeichnet, dass das in der photopolymerisierbaren Schicht B als Bindemittel (Komponente B1) enthaltene Polymer mit eingebauten quaternären und/oder quaternisierbaren Stickstoff-Atomen ein Diisocyanat-modifiziertes Polyamid ist, das zusätzlich seitenständige photopolymerisierbare Doppelbindungen eingebaut enthält.

2. Photopolymerisierbares Aufzeichnungsmaterial gemäss Anspruch 1, dadurch gekennzeichnet, dass das Diisocyanat-modifizierte Polyamid der Komponente (B1) einen K-Wert im Bereich von etwa 30 bis 75, insbesondere von etwa 40 bis 60, besitzt.

3. Photopolymerisierbares Aufzeichnungsmaterial gemäss Ansprüchen 1 und 2, dadurch gekennzeichnet, dass das in der Komponente (B1) einzusetzende Diisocyanat-modifizierte Polyamid einen Erweichungspunkt über 35°C, insbesondere über 55°C besitzt.

4. Photopolymerisierbares Aufzeichnungsmaterial gemäss Ansprüchen 1 bis 3, dadurch gekennzeichnet, dass das in der Komponente (B1) einzusetzende Diisocyanat-modifizierte Polyamid einen Gehalt an seitenständigen photopolymerisierbaren Doppelbindungen von 0,01 bis 2,5 Gew.%, insbesondere von 0,05 bis 2 Gew.%, bezogen auf das Gewicht des Diisocyanat-modifizierten Polyamids, aufweist.

5. Photopolymerisierbares Aufzeichnungsmaterial gemäss Ansprüchen 1 bis 4, dadurch gekennzeichnet, dass das in der Komponente (B1) einzusetzende Diisocyanat-modifizierte Polyamid einen Gehalt an quaternären und/oder quaternisierbaren Stickstoffatomen von 0,2 bis 2,5 Gew.%, insbesondere von 0,4 bis 1,8 Gew.%, bezogen auf das Gewicht des Diisocyanat-modifizierten Polyamids, aufweist.

6. Photopolymerisierbares Aufzeichnungsmaterial gemäss Ansprüchen 1 bis 5, dadurch gekennzeichnet, dass das in der Komponente (B1) einzusetzende Diisocyanat-modifizierte Polyamid hergestellt worden ist durch Umsetzung von einem zwei im Sinne der Isocyanatchemie reaktionsfähige Wasserstoffatome tragenden Polyamid mit einem Diisocyanat, einer im Sinne der Isocyanatchemie bifunktionell reaktionsfähigen tertiären Stickstoff-Verbindung, einer kettenverlängernden, zwei im Sinne der Isocyanatchemie reaktionsfähige Wasserstoffatome tragenden Verbindung mit seitenständigen olefinischen Doppelbindungen sowie gegebenenfalls höhermolekularen Polydiolen und/oder weiteren niedermolekularen Kettenverlängerern.

7. Photopolymerisierbares Aufzeichnungsmaterial gemäss Anspruch 6, dadurch gekennzeichnet, dass das in der Komponente (B1) einzusetzende Diisocyanat-modifizierte Polyamid hergestellt worden ist durch Umsetzung der einzelnen Komponenten in einem solchen Verhältnis, dass das NCO/OH, NH-Molverhältnis etwa 0,8 bis 1,85, insbesondere etwa 0,9 bis 1,2, beträgt.

8. Verfahren zur Herstellung von Reliefformen durch bildmässiges Belichten der photopolymerisierbaren Schicht eines Aufzeichnungsmaterials mit aktinischem Licht, Auswaschen der unbelichteten, unvernetzten Bereiche der photopolymeren Schicht mit einem Entwicklerlösungsmittel und anschliessendem Trocknen sowie gegebenenfalls Nachbelichten der erhaltenen Reliefform, dadurch gekennzeichnet, dass [ein photopolymerisierbares Aufzeichnungsmaterial gemäss einem der Ansprüche 1 bis 7] verwendet wird.

**Claims**

1.) A photopolymerizable recording material comprising a base A, a photopolymerizable layer B, and, if desired, a top layer and/or cover sheet C, the photopolymerizable layer B comprising

1. as the polymeric binder, a substantially linear, high molecular weight, thermoplastic polymer which is solid at room temperature and which possesses quaternary and/or quaternizable nitrogen atoms,
2. at least one additional photopolymerizable ethylenically unsaturated compound,
3. a photopolymerization initiator, and
4. if desired, other conventional additives,

wherein the polymer with quaternary and/or quaternizable nitrogen atoms contained in the photopolymerizable layer B as binder (component B1) is a diisocyanate-modified nylon which additonally contains photopolymerizable double bonds in side branches.

2.) A photopolymerizable recording material as claimed in claim 1, wherein the diisocyanate-modified nylon used as component (B1) has a K value of from about 30 to 75, particularly from about 40 to 60.

3.) A photopolymerizable recording material as claimed in claims 1 and 2, wherein the diisocyanate-modified nylon used as component (B1) has a softening point above 35°C, particularly above 55°C.

4.) A photopolymerizable recording material as claimed in claims 1 to 3, wherein the diisocyanate-modified nylon used as component (B1) contains from 0.01 to 2.5% by weight, particularly from 0.05 to 2% by weight, based on the weight of the diisocyanate-modified nylon, of polymerizable double bonds in side branches.

5.) A photopolymerizable recording material as claimed in claims 1 to 4, wherein the diisocyanate-modified nylon used as component (B1) contains from 0.2 to 2.5% by weight, particularly from 0.4 to 1.8% by weight, based on the weight of the diisocyanate-modified nylon, of quaternary and/or quaternizable nitrogen atoms.

6.) A photopolymerizable recording material as claimed in claims 1 to 5, wherein the diisocyanate-modified nylon used as component (B1) has been prepared by reacting a nylon, having two hydrogen atoms capable of reacting with isocyanates, with a diisocyanate, a tertiary nitrogen compound which is bifunctionally reactive with isocyanates and a chain extender which has two hydrogen atoms capable of reacting with isocyanates and possesses olefinic double bonds in side branches, with or without realtively high molecular weight polydiols and/or other low molecular weight chain extenders.

7.) A photopolymerizable recording material as claimed in claim 6, wherein the diisocyanate-modified nylon used as component (B1) has been prepared by reacting the individual components in a ratio which corresponds to an NCO/OH + NH molar ratio of from about 0.8 to 1.85, especially from about 0.9 to 1.2.

8.) A process for the preparation of a relief plate by imagewise exposure of the photopolymerizable layer of a recording material with actinic light, washing out the unexposed, non-crosslinked areas of the photopolymerizable layer with a developer solution and then drying and, if desired, aftertreating the resulting relief plate, wherein a photopolymerizable recording material as claimed in any of claims 1 to 7 is used.

**Revendications**

1.) Matériau d'enregistrement photopolymérisable à une couche support A, une couche photopolymérisable B ainsi qu'éventuellement une couche de recouvrement et/ou une feuille de recouvrement C, dans lequel la couche photopolymérisable B contient

1. comme liant polymère, un polymère thermoplastique, à haut poids moléculaire, solide à la température ambiante, en principe linéaire, et à atomes d'azote quaternaires et/ou quaternisables incorporés,
2. au moins un autre composé à insaturation éthylénique, photopolymérisable,
3. un amorceur de photopolymérisation ainsi que
4. éventuellement d'autres additifs usuels,

catactérisé par le fait que, dans la couche B photopolymérisable, le polymère, à atomes d'azote quaternaires et/ou quaternisables incorporés, en tant que liant (composant B1) est un polyamide modifié par un diisocyanate, et qui contient, incorporés, en outre, des doubles liaisons photopolymérisables latérales.

2.) Matériau d'enregistrement photopolymérisable selon la revendication 1, caractérisé par le fait que le polyamide, modifié par diisocyanate, du composant (B1) possède un indice K compris entre environ 30 et 75, en particulier entre environ 40 et 60.

3.) Matériau d'enregistrement photopolymérisable selon les revendications 1 et 2, caractérisé par le fait que le polyamide, modifié par diisocyanate, à introduire dans le composant (B1), présente un point de ramollissement supérieur à 35°C, en particulier supérieur à 55°C.

4.) Matériau d'enregistrement photopolymérisable selon l'une des revendications 1 à 3, caractérisé par le fait que le polyamide, modifié par diisocyanate, à introduire dans le composant (B1), a une teneur en doubles liaisons latérales, photopolymérisables, de 0,01 à 2,5% en poids, notamment de 0,05 à 2% en poids, rapportée au poids du polyamide modifié par diisocyanate.

5.) Matériau d'enregistrement photopolymérisable selon l'une des revendications 1 à 4, caractérisé par le fait que le polyamide, modifié par diisocyanate, à introduire dans le composant (B1), a une teneur en atomes d'azote quaternaires et/ou quaternisables de 0,2 à 2,5% en poids, en particulier de 0,4 à 1,8% en poids, rapportée au poids du polyamide modifié par diisocyanate.

6.) Matériau d'enregistrement photopolymérisable selon l'une des revendications 1 à 5, caractérisé par le fait que le polyamide, modifié par diisocyanate à introduire dans le composant (B1), a été préparé par réaction d'un polyamide, portant deux atomes d'hydrogène réactifs, dans le sens de la chimie des isocyanates, avec un diisocyanate, d'un composé d'azote tertiaire, réactif, bifonctionnel, dans le sens de la chimie des isocyanates, d'un composé à doubles liaisons oléfiniques latérales, portant deux atomes d'hydrogène réactifs, dans le sens de la chimie des isocyanates et provoquant un allongement de chaîne, ainsi qu'éventuellement des polydiols à poids moléculaires élevés et/ou d'autres allongeurs de chaîne à bas poids moléculaires.

7.) Matériau d'enregistrement photopolymérisable selon la revendication 6, caractérisé par le fait que le polyamide, modifié par diisocyanate, à introduire dans le composant (B1), a été préparé par réaction des différents composants en un rapport tel que le rapport molaire NH, NCO/OH, soit d'environ 0,8 à 1,85, en particulier environ 0,9 à 1,2.

8.) Procédé de fabrication de clichés en relief par exposition à la lumière actinique, selon une image donnée, de la couche photopolymérisable d'un matériau d'enregistrement, élimination par lavage des zones de la couche photopolymérisable non exposées, non réticulées, avec un solvant révélateur et ensuite séchage, ainsi qu'éventuellement postexposition du cliché en relief obtenu, caractérisé par le fait qu'on utilise un matériau d'enregistrement photopolymérisable selon l'une des revendications 1 à 7.